(19) Europäisches Patentamt
European Patent Office
Office européen des brevets

(11) Publication number: **0 467 199 A2**

(12) **EUROPEAN PATENT APPLICATION**

(21) Application number: **91111394.2**

(22) Date of filing: **09.07.91**

(51) Int. Cl.[5]: **H05K 3/18**, H05K 3/10, H05K 3/42

(30) Priority: **19.07.90 US 555552**

(43) Date of publication of application: **22.01.92 Bulletin 92/04**

(84) Designated Contracting States: **BE CH DE FR GB IT LI NL**

(71) Applicant: **LeaRonal, Inc.**
**272 Buffalo Avenue**
**Freeport, N.Y. 11520(US)**

(72) Inventor: **Brasch, William R.**
**11 Canterbury Lane**
**Nesconset, New York 11767(US)**

(74) Representative: **Hansen, Bernd, Dr. Dipl.-Chem. et al**
**Hoffmann, Eitle & Partner Patent- und Rechtsanwälte Arabellastrasse 4 Postfach 81 04 20**
**W-8000 München 81(DE)**

(54) **Preparation of printed circuit boards by metallization.**

(57) The invention relates to a method for the manufacture of printed circuit boards from dielectric material by drilling the dielectric material to the desired specifications, catalyzing the drilled dielectric material with a solution of colloidal particles, applying an image or organic resist film to the catalyzed board to produce the desired circuit design, immersing the imaged board into an electroless copper plating solution, and plating the catalyzed portions of the boards with electroless copper to obtain metallization.

EP 0 467 199 A2

## Technical Field

This invention relates to an improved method for the manufacture of printed circuit boards. More particularly, a method is described for selectively copper coating the non-conductive areas of a board that have previously been imaged with a resist, without copper coating the resist itself.

## Background Art

In the manufacture of printed circuit boards by the commonly used subtractive method, it is necessary to metallize the non-conductive areas of the boards. These boards are made of plastic and have a copper foil on each side. The non-conductive areas are primarily located inside the drilled holes, between the layers of copper metal. These non-conductive areas are usually metallized by coating the entire surface of the board and the holes with a coating of copper from an electroless copper plating solution. The board is then imaged to form the circuit using a polymeric resist which is, in most cases, usually a dry film which is applied to the entire surface. The board with the film is then covered with a mask that blocks the UV light which polymerizes those areas of the resist that are not covered by the mask while leaving the polymeric resist under the mask protected from UV light in its original non-polymerized state. The board is then "developed" using a developing solution which dissolves away the unpolymerized portions of the polymeric film, leaving behind the polymerized portions which delineate the circuit. The board is then prepared for plating and is electroplated in a copper electroplating solution to build up the required thickness of copper inside the holes and other areas of the board that are not covered by the polymerized polymeric film. The electroplated copper layers are then electroplated with tin or tin/lead alloy. The polymerized polymeric mask is then stripped off and the layer of electroless copper plus the initial layer of the copper laminate is etched away, thereby exposing the circuit.

Conventional commercial electroless copper solution generally utilize alkaline baths.

Such alkaline baths contain free alkali, copper, formaldehyde, chelating agents, brighteners and stabilizers. Such baths are costly, difficult to control, wasteful of copper since most of it is etched away, and is environmentally undesirable due to the presence of formaldehyde in the solution and copper in the rinse water. Generally, the boards are not electrolessly plated after application of the resist because these highly alkaline baths would attack the resist, particularly when fully aqueous photoresists are used.

Because of the disadvantages of processes using such baths, many attempts have been made in the prior art to eliminate electroless copper altogether and to metallize the holes by a direct copper electroplating method. In these processes, the boards are drilled, catalyzed, imaged and developed, then electroplated in a copper electroplating bath. Such a process is described in UK Patent Application 2,123,036. In this method, the non-conductive surfaces are catalyzed with a palladium/tin catalyst and then electroplated in a specially formulated acid copper bath containing specific additives. Copper electroplating initially takes place on the surfaces of the hole near the outside when the board is made cathodic and then gradually continues down into the hole until complete coverage with a deposit of electroplated copper is obtained. This leads to non-uniform metal distribution of copper in the holes and greater risk of pin-holes, poor adhesion to glass, and low deposit thickness.

Another similar process is described in US Patent 4,718,993. In this patent, the drilled, imaged and catalyzed printed circuit board is contacted with a dispersion of carbon black which causes carbon to adhere to the non-conductive surfaces of the holes thereby rendering them somewhat conductive. The board is then electroplated in an acid copper plating bath. Just as in the previous UK patent, copper electroplating does not immediately take place throughout the hole when the board is first made cathodic in the copper plating bath.

US Patent 4,895,739 also describes a process in which the drilled, imaged and catalyzed circuit board is first immersed in a solution that forms a catalytic metal sulfide conversion coating over the surface of the non-conductive areas. The board is then made cathodic in an acid copper electroplating bath to form the copper layer inside the hole. Just as with the previous processes copper electroplating does not immediately take place throughout the hole when first made cathodic.

PCT International Publication No. W089/08375 describes a similar method to the ones described previously. In this process, the drilled and imaged circuit board is immersed into a solution that contains at least one monomer which is then treated to form a conductive polymer on the non-conductive surfaces of the board. The board is then made cathodic in an acid copper plating bath. Just as in the previous processes, electroplating of copper does not immediately take place throughout the hole when the board is first made cathodic.

In the previous methods using high pH, formaldehyde type electroless copper baths to metallize the

non-conductive surfaces prior to imaging, copper electroplating takes place immediately throughout the hole when the board is first made cathodic in the acid plating bath. The initial electroless copper deposit inside the hole insures immediate electrodeposition of copper. In methods that involve the use of the conventional electroless copper, it is not possible to image the board prior to the electroless copper process since the alkalinity of the bath generally causes the polymerized resist to be undermined thereby permitting plating to take place under the resist. This is of greater concern when the resist is of the fully aqueous type.

US Patents 4,847,114, 4,761,304, and 4,759,952 each disclose catalyzation of circuit boards which already have been imaged with a resist; a different process than that of the present invention. However, the inventor is not aware of any process used by the printed circuit industry that drills, catalyzes, then images a printed circuit board with a polymeric resist, prior to deposition of copper from an electroless copper solution.

## Detailed Description of the Invention

In this invention, a method for making printed circuit boards is described in which a copper coated laminate is first drilled, then catalyzed, then imaged prior to electroless copper. The electroless copper plating bath deposits copper only on the non-conductive areas of the drilled board and not on the polymeric resist. The thickness of electroless copper that is deposited is only just enough to achieve complete coverage and electrical conductivity such that copper electroplating will take place immediately when the board is made cathodic in the acid copper plating bath that follows. It is important to use a specially formulated electroless copper solution that will not undermine the polymeric resist that forms the image on the board. The electroless copper solution should, therefore, not be highly alkaline but preferably close to neutral and more preferably below neutral. The most preferred electroless copper for the present invention is described in US Patent 4,877,450, the content of which is expressly incorporated herein by reference thereto. The solutions described therein operate at a pH between about 6 and 9, but those close to neutral are preferred. Other copper plating solutions are possible for the purpose of practicing this invention, that also operate at a pH close to or below neutral, i.e., from about 4.5 to about 7.5 and preferably from about 5.8 to 6.5.

Through the use of such electroless copper plating baths, the procedure for making a printed circuit board is then drilling the holes, catalyzing the non-conductive areas, imaging, depositing a very thin layer of electroless copper, electroplating copper upon the electroless copper deposit to the required thickness, and then followed by the usual steps of solder plating, etching, and so forth. The manufacturing method described herein results in substantial savings in chemicals, processing time, and is safer to the environment than the prior art methods.

The polymeric films used to form the image are generally classified into three types: fully organic, semi-aqueous, and fully aqueous. The classifications refer to the developing solutions that are used to dissolve away the unpolymerized portions of the film that did not receive any ultraviolet light during the exposure of the board to light. The fully organic film uses an organic solvent as the developing solution, while the semi-aqueous film uses a semi-aqueous developing solution that also contains a small amount of organic solvent, and the fully aqueous film uses a developing solution that is fully aqueous with a small amount of alkali such as sodium carbonate.

For environmental reasons, it is most desirable to use a fully aqueous film, since the developing solutions that contain organic solvents are most difficult to dispose of. The fully aqueous polymeric films are even more sensitive to undercutting in an electroless copper plating bath than the semi-aqueous or fully organic films. The solutions described in US Patent 4,877,450 are most advantageously used in the present invention when fully aqueous polymeric films are used to form the image. The conditions of operation of the described solutions are altered slightly, in that the preferred operating pH is about 5.8 to 6. The preferred operating times and temperatures are the same as those described in the patent.

Thus, the preferred formaldehyde-free electroless copper plating solutions contain a solution soluble divalent copper compound; a reducing agent for the copper compound; a complex and chelating agent mixture of an amine alkanol compound having at least one alkyl group of 1 to 3 carbon atoms, and an ethylene diamine compound of the formula

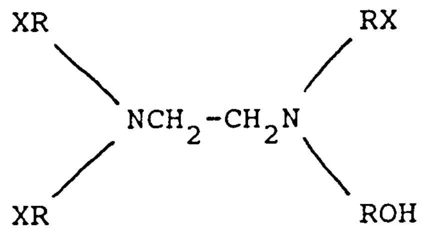

wherein R is an alkyl moeity having between 1 and 3 carbon atoms and X is -OH or -COOH. As noted above, this solution has a pH between 5.8 and 6.

Also, the complexing and chelating agent mixture is present in an amount sufficient to provide stability to the solution and to enable the solution to provide a uniform plating rate of copper upon the plastic circuit board substrates which are immersed therein.

The preferred reducing agent is dimethylamine borane and is present in the solution in a concentration of between about 5 and 10 g/l. The copper compound may be present in a concentration of between 1/2 and 2 g/l. Also, the amine alkanol compound is generally present in a concentration of between about 5 and 100 ml/l, while the ethylene diamine compound is present in a concentration of between 1 and 10 g/l.

Preferred amine alkanol compounds include mono-, di- and tri-ethanol amines, while preferred ethylene diamine compounds include hydroxyethyl ethylene diamine triacetic acid; tetrahydroxy ethylene diamine; and dihydroxymethyl ethylene diamine diacetic acid.

Advantageous electroless copper deposits and solution operation can be obtained by using the solution in a pH range of below 7.5 at a temperature of about ambient to 150° F with essentially any complexing or chelating agent mixture in that the amount of dimethylamine borane reducing agent lost to side reactions is reduced to an extremely minimized and low value. An acid such as sulfuric acid can be added to the solution in an amount sufficient to adjust the pH to the desired range. Also, if desired, although not necessary, the solution may contain one or more addition agents for improving a characteristic of the solution or the resultant electroless copper deposit.

## Examples

The following examples illustrate the selective coating process of the invention.

### Example 1

Two 9" x 14" FR-4 epoxy-glass, copper clad panels were, drilled and deburred and then processed as follows:

a) Removal of surface soils and particulate matter by immersing the panels for 5 minutes at 160-180° F in a mild alkaline cleaner; followed by rinsing in water.

b) Conditioning of the non-conductive areas in the panel holes for adequate catalyst absorption by immersion in Conditioner 1117 (commercial product of LeaRonal, Inc.), a surfactant solution, for 5 minutes at 150-170° F; followed by rinsing in water.

c) Immersion of the conditioned panels in 30% solution of hydrochloric acid for 2 minutes at ambient temperatures.

d) Catalyzation of the non-conductive surfaces by immersing the panels in the standard type palladium-tin colloid solution for 5 minutes at ambient temperature; followed by rinsing in water.

e) The panels were then air dried then mechanically scrubbed prior to application of the circuit image mask.

f) The circuit image was formed on the panels in the conventional manner of laminating, exposing, and developing using Ordyl 838 (commercial product of LeaRonal, Inc.), a fully aqueous polymeric resist.

The panels were then placed on plating racks for the electroplating operation. Further processing was as follows:

g) Removal of the residue of the unpolymerized photoresist by immersion of the panels in a 1% solution of sodium carbonate for 30 seconds at ambient temperature; followed by rinsing in water.

h) Activation the catalyzed non-conductive areas and copper surfaces by immersion of the panels in an acidified solution of 60 g/l of sodium persulfate for 2 minutes at ambient temperature; followed by rinsing in water.

i) The non-conductive areas of the panels were then rendered conductive by immersion in the electroless bath described in Example 1 of US Patent 4,877,450. The immersion time was 12 minutes at a temperature of 140 °F. The thickness of the copper coating thus produced was 5 microinches measured by the weight gain method. The pH of the bath was about 6.

j) The panels were rinsed in water, acid dipped for 1 minute, then electroplated in a standard commercial acid copper electroplating bath for 40 minutes plating time at a cathod current density of 25 ASF.

k) After rinsing, the panels were electroplated in a standard commercial tin/lead plating bath for 15 minutes at a cathode current density of 15 ASF.

l) The dry film resist mask was then removed in a weak caustic solution followed by complete removal of the copper clad areas exposed by etching in a standard ammoniacal copper etch solution.

The panels were examined for circuit line definition, adhesion, and coverage in the holes. The results were excellent and consistent with present production quality using conventional methods.

Example 2 (Comparison)

Example 1 was repeated with the exception of eliminating Step i, the electroless plating bath.

After careful examination the panels exhibited defects in the holes. The plated coating was non-uniform with many areas not coated at all.

Example 3

Two 24" x 18" multilayer printed circuit panels containing four circuit layers were desmeared of resin material from the copper interconnects in the holes. The panels were then processed as in Example 1.

The panels were examined for adhesion and coverage. The results were excellent, the coverage was complete, and the adhesion flawless, even after repeated thermo-shock testing.

Example 4

Two 9" x 14" copper clad epoxy-glass panels with drilled holes were processed as in Example 1 except the panels were electroplated in the copper bath for only 2 minutes. The panels were dried and examined for coverage in the holes. Complete uniform coverage was noted in all holes.

Example 5 (Comparison)

Two panels as per Example 4 were processed as described in Examples 8-9 of US Patent 4,895,739. The copper electroplating was conducted for 2 minutes.

The boards were examined for coverage in the holes. Incomplete coverage was observed on about 50% of these holes.

Example 6

Two panels were processed as described in Example 1 of UK Patent Application 2,123,036. With one of the panels being immersed in step i of Example I the present invention prior to electroplating.

Complete coverage was noted on the panel that was electroless plated. On the other panel only some of the hole walls were covered.

In addition, the UK process requires specific additives in the electroplating step to improve the conductivity of the non-conductive material to achieve complete coverage. The process of this invention produces a perfect conductive coating before the electroplating step; therefore, no special techniques or additives are required in the electroplating step.

Example 7

Two panels, as in Example 1 above, were processed with a semi-aqueous resist (Riston 215R from Dupont Co.) in place of the fully aqueous resist of Example 1. Also, a conventional alkaline electroless bath (Coppermerse 80 from LeaRonal, Inc.) was used in step i in place of the electroless copper bath of Example 1. The immersion time in the electroless bath was 3 minutes and temperature was 100 °F.

The results were similar to Example 1; complete coverage and excellent adhesion were observed.

While it is apparent that the invention herein disclosed is well calculated to fulfill the objects above

stated, it will be appreciated that numerous modifications and embodiments may be devised by those skilled in the art, and it is intended that the appended claims cover all such modifications and embodiments as fall within the true spirit and scope of the present invention.

## Claims

1. A method for the manufacture of printed circuit boards from a dielectric material which comprises:
   drilling the dielectric material to the desired specifications;
   catalyzing the drilled dielectric material with a solution of colloidal particles;
   applying an image or organic resist film to the catalyzed board to produce the desired circuit design; and
   plating the catalyzed portions of the boards with electroless copper to obtain the desired circuit design.

2. The method of claim 1 wherein the organic resist film is of a fully aqueous developable polymeric material.

3. The method of claim 2 which further comprises formulating the electroless copper plating solution at a pH of between about 4.5 and 7.5 to prevent undermining of the organic resist film.

4. The method of claim 1 which further comprises electroplating copper onto the electroless copper deposit.

5. The method of claim 4 which further comprises electroplating a tin-lead deposit upon the copper deposit.

6. The method of claim 1 wherein the electroless copper plating solution comprises:
   a solution soluble divalent copper compound; an amine borane reducing agent for said copper compound;
   a complexing and chelating agent mixture of an amine alkanol compound having at least one alkyl group of 1 to 3 carbon atoms and an ethylene diamine compound of the formula

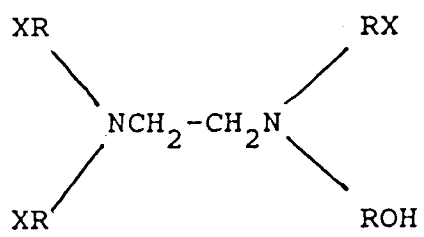

   wherein R is an alkyl moeity having between 1 and 3 carbon atoms and X is -OH or -COOH;
   said solution having a pH between about 4.5 and 7.5 said complexing and chelating agent mixture being present in an amount sufficient to provide stability to the solution and to enable the solution to provide a uniform plating rate of copper upon a substrate which is immersed therein.

7. The solution of claim 6 wherein the reducing agent is dimethylamine borane and is present in the solution in a concentration of between 2 and 10 g/l.

8. The solution of claim 6 wherein the amine alkanol compound is present in the solution of between about 5 and 100 ml/l.

9. The solution of claim 6 wherein the amine alkanol compound is a mono-, di- or tri-ethanol amine.

10. The solution of claim 6 wherein the ethylene diamine compound is present in the solution in a concentration of between 1 and 10 g/l.

**11.** The solution of claim 6 wherein the ethylene diamine compound- is hydroxyethyl ethylene diamine triacetic acid; tretrahydroxy ethylene diamine; or dihydroxymethyl ethylene diamine diacetic acid.

**12.** The solution of claim 6 further comprising one or more addition agents for improving the characteristics of the solution or the resultant electroless copper deposit.

**13.** The solution of claim 6 wherein the pH range is between about 4.5 and7.5and wherein the temperature is between ambient to 150 $^{\circ}$ F.

**14.** The solution of claim 13 which further comprises an acid in amount sufficient to adjust the pH to the desired range.

**15.** The solution of claim 6 wherein the copper compound is present in a concentration of between 1/2 and 2 g/l.

**16.** The method of claim 1 which further comprises conditioning the dielectric material prior to catalyzing with the colloidal particles.

**17.** The method of claim 16 wherein the conditioning step includes treating the boards with a surfactant solution.

**18.** The method of claim 1 wherein the dielectric material is catalyzed with a palladium-tin colloid.

**19.** The method of claim 1 which further comprises activating the catalyzed dielectric material prior to the electroless copper plating step.

**20.** The method of claim 1 wherein the dielectric material includes a copper metal foil on each side and the dielectric material to be plated is the exposed hole walls obtained by drilling through the dielectric material.

**21.** A method for the manufacture of printed circuit boards from a laminate of dielectric material having a copper foil on each side which comprises:

drilling holes in the laminate according to the desired specifications to expose the dielectric material forming the hole walls;

catalyzing the hole walls with a solution of colloidal particles;

applying an image or organic resist film to the laminate after the catalyzing step to produce the desired circuit design;

plating the catalyzed hole walls with electroless copper to obtain the desired electrical connections between the copper foils.

**22.** The method of claim 21 wherein the organic resist film is of a fully aqueous developable polymeric material.

**23.** The method of claim 22 which further comprises formulating the electroless copper plating solution at a pH of between 4.5 and 7.5 to prevent undermining of the organic resist film.

**24.** The method of claim 23 which further comprises electroplating copper onto the electroless copper deposit.

**25.** The method of claim 24 which further comprises electroplating a tin-lead deposit upon the copper deposit.

**26.** The method of claim 25 which further comprises conditioning the dielectric material prior to catalyzing with the colloidal particles.

**27.** The method of claim 26 wherein the conditioning step includes treating the boards with a surfactant solution.

**28.** The method of claim 27 wherein the dielectric material is catalyzed with a palladium-tin colloid.

**29.** The method of claim 28 which further comprises activating the catalyzed dielectric material prior to the electroless copper plating step.

**30.** The method of claim 29 which further comprises removing the resist image and etching the exposed copper surfaces of the laminate to obtain the final circuit board.